(19) **Europäisches Patentamt / European Patent Office / Office européen des brevets**

(11) **EP 4 764 898 A1**

(12) # EUROPEAN PATENT APPLICATION

(43) Date of publication:
24.06.2026 Bulletin 2026/26

(21) Application number: 24222036.6

(22) Date of filing: 20.12.2024

(51) International Patent Classification (IPC):
**G06F 16/906** (2019.01)   **G01R 31/00** (2006.01)
**G06N 3/00** (2023.01)

(52) Cooperative Patent Classification (CPC):
**G06F 16/906; G01R 31/367; G06N 3/0455;
G06N 3/09**; G06N 3/044; G06N 3/084

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Robert Bosch GmbH
70442 Stuttgart (DE)**

(72) Inventors:
• **Avner, Orly
Haifa (IL)**
• **Linial, Ori
Haifa (IL)**
• **Di Castro, Dotan
3440619 Haifa (IL)**

(54) **DEVICE AND METHOD OF CONSTRUCTING DIFFERENTIAL EQUATIONS INCORPORATING EXPERT KNOWLEDGE**

(57)    A computer-implemented method of iteratively constructing a system of differential equations for an input time series (110) using a machine learning system comprising an encoder (130) and a decoder (160), wherein the input time series is a measured time series of an electrical energy storage, said method comprising: Propagating the input time series through the encoder (130) to obtain a signal encoding of said input time series (110). Generating an initial shared embedding (150) from the output of the signal encoding and iteratively applying the decoder (160) on the shared embedding to iteratively outputting individual symbols of the system of differential equations and aggregate the individual symbols to the system of differential equations, wherein after each outputted symbol by the decoder, the symbol is passed to an equation embedding (141) and the shared embedding (150) is updated by concatenating the signal encoding (130) with an encoding from the equation embedding (141) for the current aggregated system of differential equations. Outputting the aggregated system of differential equations and determining depending on the outputted system of differential equations a de-/charging cycle or state of health for the electrical energy storage, wherein the equation embedding (141) contains an expert knowledge embedding (142) comprising embedding expert knowledge about the electrical energy storage to the equation embedding (141), wherein the expert knowledge comprises a count of overall symbols (191) of the system of differential equations and/or categorical labels (192) assigned to the individual symbols, wherein the expert knowledge is encoded and concatenated or numerically added to the equation embedding (141).

Fig. 2

**Description**

The invention provides a method for constructing a system of differential equations from multi-dimensional time series data. This method incorporates expert knowledge and utilizes an architecture inspired by Large Language Models (LLMs). The invention also encompasses a computer program, a machine-readable storage medium, and a system for implementing the method.

Prior art

The authors of the publication https://arxiv.org/pdf/2304.10336 developed a method for "Neural Symbolic Regression with Hypothesis" that enables the explicit incorporation of assumptions about the expected structure of the ground-truth expression into the prediction process for the symbolic regression for linear equations and outputs a set of candidates of predicted equations.

The known methods from the prior art are limited to static equations an output a set of candidates of predicted linear equations. One objective of the present invention is to overcome these limitations to succeed in modelling multi-dimensional time series data using differential equations.

Advantages of the invention

The known methods from the prior art only support static equations with incorporation of expert knowledge but do not support differential equations. Differential equations in particular, systems of differential equations are of high interest since they are well suited for describing dynamic physical systems. The incorporation of expert knowledge to the construction of the systems of differential equations has some further advantages as already existing expert knowledge can lead to faster and better results by providing constraints to the machine learning system. Additionally, the known methods from the prior art output a set of predicted linear equations which requires a subsequent step to select a suitable equation from this set.

Disclosure of the invention

The invention provides a computer-implemented method of iteratively constructing a system of differential equations for an input time series using a machine learning system comprising an encoder and a decoder, wherein the input time series is a measured time series of an electrical energy storage, said method comprising:

Propagating the input time series through the encoder to obtain a signal encoding of said input time series;
Generating an initial shared embedding from the output of the signal encoding; and
Iteratively applying the decoder on the shared embedding to iteratively outputting individual symbols of the system of differential equations and aggregate the individual symbols to the system of differential equations, wherein after each outputted symbol by the decoder, the symbol is passed to an equation embedding and the shared embedding is updated by concatenating the signal encoding with an encoding from the equation embedding for the current aggregated system of differential equations;
Outputting the aggregated system of differential equations; and Determining depending on the outputted system of differential equations a de-/charging cycle or state of health for the electrical energy storage;
With the improvement that the equation embedding contains an expert knowledge embedding comprising embedding expert knowledge about the electrical energy storage to the equation embedding; wherein the expert knowledge comprises a count of overall symbols of the system of differential equations and/or categorical labels assigned to the individual symbols; wherein the expert knowledge is encoded and concatenated or numerically added to the equation embedding.

A system of differential equations is a set of one or more differential equations that describes the relationships between variables and their derivatives with respect to time and/or another independent variables. Systems of differential equations characterize dynamic behavior of signals and/ or physical systems such as an electrical energy storage, in particular a voltage, current, and/or temperature measurements over time.

A time series is in particular understood as a sequence of data points indexed in time order, representing measurements taken from a technical system, in particular an electrical energy storage. The time series is an input for the here described method. Each data point in the time series can be a single value or a vector of values, which means in particular the time series can be multidimensional. In the context of an electrical energy storage system, the time series data can in particular represent voltage, current, and/or temperature measurements over time. Preferably, the method for constructing the system of differential equations can be performed offline using previously measured time series data and/ or online using a sliding window approach. In the offline case, a batch of historical time series data is processed to derive the system of differential equations. Alternatively, in the online case, the method might continuously process incoming time series data within a sliding window of a defined size. The window size can be adjusted dynamically, particularly in response to the measurement frequency, to ensure appropriate data capture.

Electrical energy storage devices store electrical energy for later use. Common examples comprise batteries, capacitors, fuel cells, and pumped hydroelectric storages, that are in particular used in vehicles, robots, mobile devices or energy grids. A de-/charging cycle refers in particular to the process of fully de-charging an electrical energy storage device and then fully charging it. Modeling the de-/charging cycle as a system of differential equations offers several applications such as controlling the charging, predicting the charging time as well as the remaining operation time until a re-charging is required and/ or optimizing the charging process. In a preferred embodiment where the electrical energy storage powers a vehicle, the system of differential equations can be used to predict the remaining range of the vehicle and determine charging strategies. A state of health of an electrical energy storage device refers in particular to a value that describes its current health status compared to a new unit of the same type. It indicates how much of its original capacity and performance the electrical energy storage device retains. The state of health is used, for example, for condition monitoring, lifetime prediction, and charge management of electrical energy storage devices. In a preferred embodiment where the electrical energy storage powers a vehicle, the system of differential equations can be used to estimate the state of health of the electrical energy storage and determine is remaining lifetime.

An encoder in the context of the here disclosed invention is in particular a component of the machine learning system that transforms an input into a fixed-length vector representation, called as encoding. The encoder can also comprise an embedding component that is a learned vector representation of the input. Preferably, the encoder can be a neural network. In case of the input time series, the encoder provides the signal encoding.

A decoder is, in particular a component of the machine learning system that iteratively constructs the system of differential equations. It takes the shared embedding as an input and outputs individual symbols of the differential equations. The decoder can preferably be a recurrent neural network or a transformer network. The shared embedding can be understood as a vector representation of the current state of the constructed system of differential equations. It is initialized based on the signal encoding and updated iteratively as new symbols are added to the system of differential equations. A termination criterion for the iterative process can be defined depending on the application, it can in particular depend on definitions done in the expert knowledge or a fixed maximum number of iterations and or symbols alternatively the iteration termination can be initiated by the decoder due to specified metrics such as confidence values of an underlying neural network or an end of sentence symbol.

Symbols in the context of the here described invention are preferably a set of defined mathematical operators (e.g. addition, multiplication, division and so on), functions (such as sin, cosin, exponential functions) and/ or punctuation marks such as parentheses. A symbol can also represent more complex mathematical operations such as complete terms comprising combinations of the symbols described above (e.g. a sin of an exponential function).

A shared embedding can in particular be obtained by concatenating an encoded equation embedding to the signal encoding. The shared embedding serves as an input of the decoder.

An equation embedding is preferably a vector representation that encodes the structure and components of a mathematical equation, such as a differential equations, allowing it to be processed by a machine learning model. The equation embedding can in particular comprise an encoding step that transforms the vector to a two dimensional embedding space.

An expert knowledge embedding is in particular a vector representation of expert knowledge about the system of differential equations. It is a part of the equation embedding and can be added to the shared embedding by concatenating or numerically adding it to the equation embedding. The expert knowledge can include information such as the number of symbols expected in the final system of equations and/or categorical labels assigned to individual symbols. In another embodiment, the expert knowledge can also contain information of relations between parameters for example if one operation represented by a symbol is nested into another operation represented by another symbol. Additionally, the expert knowledge can also represent more abstract information such as symmetry, periodicity and or signs of function values. The consideration of expert knowledge can significantly improve the construction of the system of differential equations by providing constraints to the decoder. This reduces the iterations that are needed to find the system of differential equations, that describes the time series and ensures that the system of differential equations is in line with expectations of an expert providing the expert knowledge.

In a further embodiment, the system of differential equations can also be used to detect anomalies by comparing the system of differential equations for a time series to a defined good-case system of differential equations. Depending on the anomaly detection the electrical energy storage can be set to a failure mode and/ or other systems can be triggered. In a preferred embodiment where the electrical energy storage powers a vehicle, the failure mode can for example comprise a shutdown of the vehicle or a restart. For electrical energy storages that power safety critical devise with redundant power sources (e.g. medical ventilator, alarm systems) the anomaly detection can in particular be used to switch the electrical energy storage in case of anomalies.

In a preferred embodiment of the invention the categorical labels assigned to the symbols are encoded by a positional numeral system, wherein the base of the positional numeral system is equivalent to a count of distinct categorical labels for each symbol.

A positional numeral system represents numbers using a fixed base, examples are decimal, ternary or binary systems. A position of a digit determines its value, multiplied by powers of the base. In this embodiment, the base of the positional numeral system corresponds to the count of distinct categorical labels available for each symbol, allowing efficient representation of distinct categories. Using a positional numeral system is especially efficient when the count of possible categories is large. This reduces the dimensionality of the expert knowledge embedding, in particular, the expert knowledge can be represented by just one number that is the sum of the positional numeral system. In another preferred embodiment, the positional numeral system can also be used to encode other information besides the symbols in particular, if the expected function has some symmetrical, periodical and/ or converging behavior.

In a further embodiment the base of the positional numeral system is three, wherein the categorical labels assigned to the symbols represent three categorical labels, preferably if the respective symbol exists, does not exist or if there is no knowledge about its existence.

A ternary system is a specific positional numeral system that has the base three. Therefore, the expert knowledge embedding based on the positional numeral system with base three can represent three distinct categorical labels of the symbols. In particular, the expert knowledge can express if a symbol exists, does not exist or if there is no knowledge about its existence. The categorical label that there is no knowledge about the symbol's existence has the advantage that no constraints need to be set in case there is no expert knowledge about the related symbol.

In another preferred embodiment wherein the machine learning system is trained using a supervised learning approach comprising the steps of: providing a training dataset comprising a plurality of examples, each example including a time series and a corresponding ground truth system of differential equations representing the time series; for each example in the training dataset:

Propagating the time series through the encoder to obtain a signal encoding; generating the shared embedding with the signal encoding;
processing the corresponding ground truth of systems of differential equations by the equation embedding to obtain a ground truth equation embedding;
adding or concatenating the ground truth equation embedding to the shared embedding;
decoding the shared embedding using the decoder to generate a predicted system of differential equations;
calculating a loss value based on a difference between the predicted system of differential equations and the ground truth system of differential equations;
updating parameters of the machine learning system based on the calculated loss value.

Training using a supervised learning aims to minimize the difference between the predicted system of equations and the ground truth system. For such an optimization, in particular a gradient-based optimization algorithm to minimize the loss value over the training dataset can be used. Therefore, the parameters of the machine learning system are updated. The parameters of the machine learning system are, in particular, the internal variables that the machine learning system learns during the training process. It should be noted, that hyperparameters of the machine learning system, in particular training rate and/ or batch size can also be updated during the training.

A ground truth system of differential equations can be determined by an expert based on the time series, alternatively a time series can be generated synthetically based on a given ground truth system of differential equations. Training datasets can also comprise ground truth systems of differential equations from both methods. This enables flexibility in the training of the machine learning system to cover also different scenarios, in particular real-world scenarios where the time series is measured and the ground truth system of differential equations is determined by an expert as well as rare corner cases that can be generated synthetically.

In a preferred embodiment the training dataset additionally comprises ground truth expert knowledge describing the corresponding ground truth system of differential equations, wherein the ground truth expert knowledge is numerically added or concatenated to the equation embedding, together with the corresponding ground truth system of differential equations, to obtain the ground truth equation embedding.

In this embodiment, the machine learning system is preferably trained with a training data set that comprises ground truth expert knowledge corresponding to each ground truth system of differential equations.

The ground truth expert knowledge comprises samples of expert knowledge, in particular a count of overall symbols of the ground truth system of differential equations, information about the behavior of the expected function (e.g. if it has symmetrical, periodical or converging behavior and/ or if it is positive or negative signed) and/or categorical labels assigned to the individual symbols (e.g. information about the existence of the symbol in the ground truth system of differential equations), in particular the ground truth expert knowledge can also contain samples without expert knowledge of the system of differential equations. A split between training data sets with and without ground truth expert knowledge can be defined depending on the application. For example, the training dataset can be split according to the number of available categorical labels, in particular the amount of training data sets without ground truth expert knowledge can be one third in case of three categorical labels. Including training data sets with and without ground truth expert knowledge to the training enables the decoder to process shared embeddings with and without expert knowledge which makes the method flexible for different applications (e.g. when no expert knowledge is available for an unknown system). Additionally training the machine learning system with ground truth expert knowledge can speedup the training process as the machine learning system optimizes faster due to constraints given by the ground truth expert knowledge.

A further embodiment comprises a computer program that is configured to cause a computer to execute the method with all of its steps if the computer program is carried out by a processor.

A further embodiment comprises machine-readable storage medium on which the computer program is stored.

A further embodiment comprises a system that is configured to carry out the steps of the invented method.

Embodiments of the invention will be discussed with reference to the following figures in more detail. The figures show:

Fig. 1    a high-level architecture for training;

Fig. 2    a high-level architecture for inference;

Fig. 3    a schematic flow chart of an embodiment of the invention.

Description of the embodiments

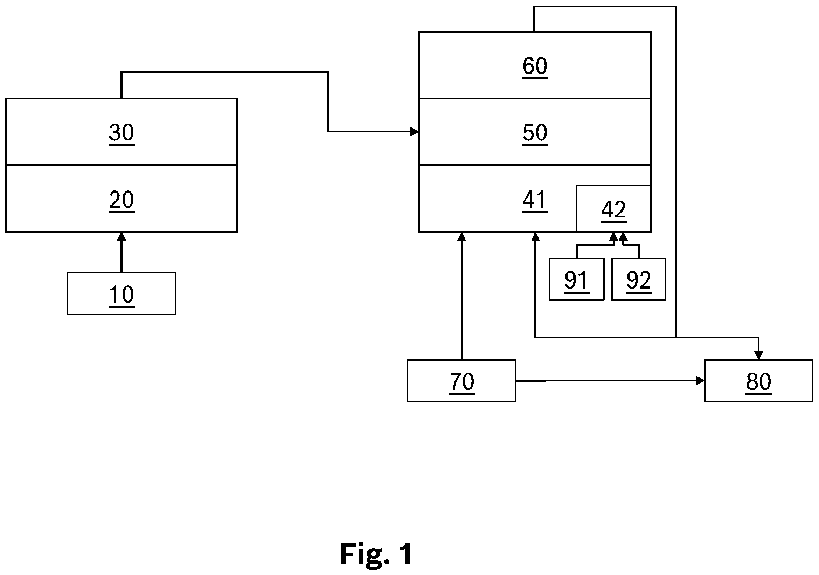

Fig. 1 shows a high-level architecture for training of a machine learning system iteratively constructing a system of differential equations for an input time series that is, in particular, a measured time series of an electrical energy storage. This architecture comprises a signal embedding (20) that gets N time series (10) with an amount of $T_n$ data points as an input, with $T_n$ representing a length of $n$-th time series in timesteps. The signal embedding (20) transforms the time series (10) to a $K \times T$ dimensional feature tensor $m_{fsig}$, wherein $K$ is the number of features for each data point. Below is an example of $m_{fsig}(1)$ for a time series $T_1$ and $N = 1$ where feature vectors are depicted separated for better visualization. The time series $T_1$ is transformed to $m_{fsig}$ by applying a conversion to a floating point representation followed by zero padding and finally applying a neuronal network.

$$m_{fsig} = \begin{bmatrix} 0.13 \\ \dots \\ 1.73 \end{bmatrix}, \begin{bmatrix} -0.2 \\ \dots \\ 0.72 \end{bmatrix}, \dots \qquad (1)$$

The feature tensor $m_{fsig}$ is now propagated through a signal encoder (30) which is a transformer followed by a pooling layer. The signal encoder (30) encodes $m_{fsig}$ to an $E_{sig}$-dimensional vector $m_{sig}$ representing the time series. An example for $m_{sig}$ can be seen in (2).

$$m_{sig} = \begin{bmatrix} -0.23 \\ \dots \\ 1.33 \end{bmatrix} \qquad (2)$$

For the training of the machine learning system an equation embedding (41) gets a ground truth system of differential equations (70) as an input, wherein the ground truth system of differential equations (70) is representing the time series (10). The ground truth system of differential equations (70) can be determined by an expert based on the time series (10), alternatively the time series (10) can be generated synthetically based on the ground truth system of differential equations (70). An example for a ground truth system of differential equations (70) is shown in equation (3) for a one dimensional differential equation.

$$\frac{\partial x}{\partial t} x(t) = sin(e^{-t}) \qquad (3)$$

The ground truth system of differential equations (70) gets tokenized to a $S$ dimensional vector $m_{eqt}$, with $S$ as the number of symbols in the equation. The tokenization can in particular be done by a simple lookup table. In the example (4) this table could be setup like shown below

| symbol | ... | $e^{(...)}$ | ... | $-1 \cdot (...)$ | ... | $sin(...)$ | ... |
|--------|-----|-------------|-----|------------------|-----|------------|-----|
| token | ... | 7 | ... | 9 | ... | 14 | ... |

$$m_{eqt} = [14, \quad 7, \quad 9, \quad ...] \tag{4}$$

After tokenization, an embedding is applied that transforms $m_{eqt}$ to an $E_{eq} \times S$ dimensional tensor $m_{eq}$ that represents a first part of the equation embedding.

$$m_{eq} = \begin{bmatrix} 19 \\ ... \\ -0.68 \end{bmatrix}, \begin{bmatrix} 0.1 \\ ... \\ 0.8 \end{bmatrix}, ... \tag{5}$$

A second part of the equation embedding is provided by a ground truth expert knowledge embedding (42). In this embodiment, the ground truth expert knowledge embedding (42) gets two inputs, a count of overall symbols (91) of the ground truth system of differential equations (70) and categorical labels (92) assigned to the individual symbols of the ground truth system of differential equations (70). Preferably the categorical labels (92) can be encoded by a ternary system. An example illustration of the ternary system encoding is shown in the table below.

| Symbol | ... | $tan(...)$ | $cos(...)$ | $sin(...)$ | $e^{(...)}$ |
|--------|-----|------------|------------|------------|-------------|
| Positional value | ... | $3^3$ | $3^2$ | $3^1$ | $3^0$ |
| Exists (0) | ... | | | x | x |
| Does not exist (1) | ... | | x | | |
| No knowledge (2) | ... | x | | | |
| Mapping | ... | $2 \cdot 3^3 = 54$ | $1 \cdot 3^2 = 9$ | $0 \cdot 3^1 = 0$ | $2 \cdot 3^0 = 2$ |

Getting a sum over the mapping values leads to an encoding of

$$m_{ekc} = 65. \tag{6}$$

For the count of overall symbols, no encoding is needed as the count directly leads to ($sin()$, $exp()$, negative signed operand, operand t)

$$m_{ekn} = 4. \tag{7}$$

$m_{ekn} = 4.$ (7)

The equation embedding (41) and the expert knowledge embedding (42) are now concatenated together, for the here shown example with equations (5), (6) & (7) this leads to $m_{eqek}$, an $E_{eq} + 2 \times S$ tensor as shown in (8).

$$m_{eqek} = \begin{bmatrix} 4 \\ 65 \\ 19 \\ ... \\ -0.68 \end{bmatrix}, \begin{bmatrix} 4 \\ 65 \\ 0.1 \\ ... \\ 0.8 \end{bmatrix}, ... \tag{8}$$

The tensor $m_{eqek}$ is now concatenated together with $m_{sig}$ to obtain a shared embedding (50). Based on the used example, the shared embedding (50) is shown in equation (9).

$$m_{sh} = \begin{bmatrix} -0.23 \\ \ldots \\ 1.33 \\ 4 \\ 65 \\ 19 \\ \ldots \\ -0.68 \end{bmatrix}, \begin{bmatrix} -0.23 \\ \ldots \\ 1.33 \\ 4 \\ 65 \\ 0.1 \\ \ldots \\ 0.8 \end{bmatrix}, \ldots \tag{9}$$

The shared embedding (50) is now processed by a decoder (60). Preferably the decoder is a transformer followed by a head to output the symbols of a predicted system of differential equations. The symbols of the predicted system of differential equations are feedback to the equation encoder (41) and to a loss function (80). Preferably, the loss function is a cross entropy loss applied on the tokens of the equation strings. The loss function (80) with respect to the parameters of the machine learning system can be optimized by a standard training approach: e.g. backpropagation of the loss through the entire system. In particular, the optimization can happen based on gradient descent. This described cycle can be repeated for each symbol of the ground truth system of differential equations (70) until the loss function reaches a defined value.

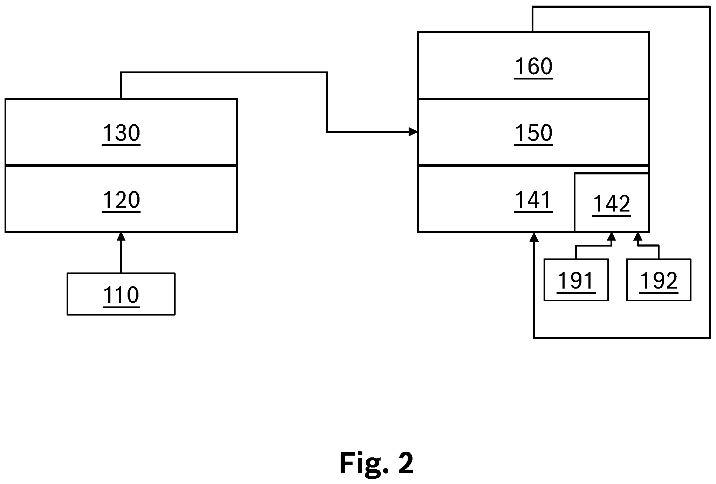

Fig. 2 shows a high-level architecture for inference. The architecture is the same as for training but without the ground truth system of differential equations (70) and without the loss function (80).

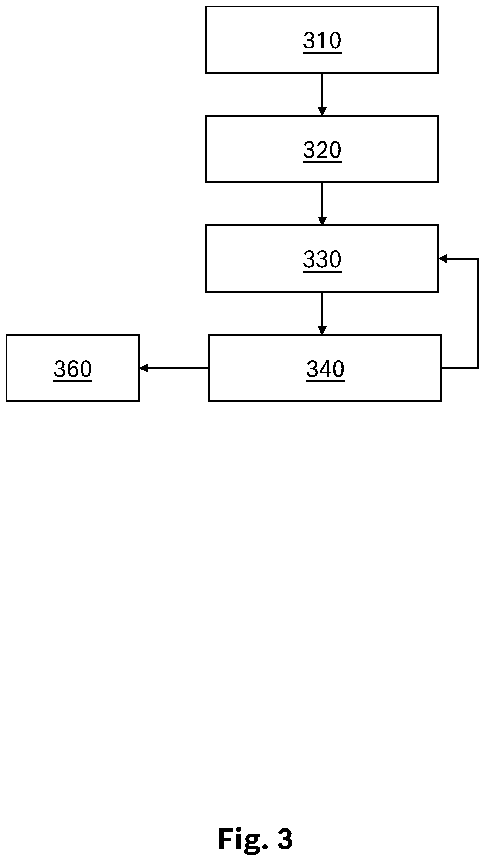

Fig. 3 shows a schematic flow chart of an embodiment of the invention for inference. The method starts with step 310. In this step the machine learning system is initialized. In particular, the equation embedding is set to zero.

In step 320 a time series (110) is processed by a signal embedding (120) and signal encoder (130) and forwarded to the shared embedding (150).

In step 330 the equation embedding (141) and expert knowledge embedding (142) on the expert knowledge (191, 192) is performed. In the first iteration of the method, the equation embedding only comprises the expert knowledge embedding. In further iterations, the equation embedding also incorporates outputted symbols from a decoder (160). The equation embedding and the expert knowledge embedding are then concatenated together and added to the shared embedding (150).

In step 340 the shared embedding is processed by the decoder (160). The decoder (160) outputs a new symbol for the system of differential equations and aggregates it to the already existing symbols for each iteration. The symbols are feedback to the equation embedding in step 330. The iterations continue until the defined termination criterion is reached, preferably a maximum number of symbols.

If the termination criterion is reached, the method goes from step 340 to step 350 which is the end of the method.

## Claims

1. A computer-implemented method of iteratively constructing a system of differential equations for an input time series (110) using a machine learning system comprising an encoder (130) and a decoder (160), wherein the input time series is a measured time series of an electrical energy storage, said method comprising:

   Propagating the input time series through the encoder (130) to obtain a signal encoding of said input time series (110);
   Generating an initial shared embedding (150) from the output of the signal encoding; and
   Iteratively applying the decoder (160) on the shared embedding to iteratively
   outputting individual symbols of the system of differential equations and aggregate the individual symbols to the system of differential equations, wherein after each outputted symbol by the decoder, the symbol is passed to an equation embedding (141) and the shared embedding (150) is updated by concatenating the signal encoding (130) with an encoding from the equation embedding (141) for the current aggregated system of differential equations;

      Outputting the aggregated system of differential equations; and Determining depending on the outputted system of differential equations a de-/charging cycle or state of health for the electrical energy storage; said method **characterized in that** the equation embedding (141) contains an

   expert knowledge embedding (142) comprising embedding expert knowledge about the electrical energy storage to the equation embedding (141); wherein the expert knowledge comprises a count of overall symbols (191) of the system of differential equations and/or categorical labels (192) assigned to the individual symbols; wherein the expert knowledge is encoded and concatenated or numerically added to the equation embedding (141).

2. The method according to any of the preceding claims, wherein the categorical labels (192) assigned to the symbols are encoded by a positional numeral system, wherein the base of the positional numeral system is equivalent to a count of distinct categorical labels for each symbol.

3. The method according to claim 2, wherein the base of the positional numeral system is three, wherein the categorical labels (191) assigned to the symbols represent three categorical labels, preferably if the symbol exists, does not exist or if there is no knowledge about its existence.

4. The method according to any of the preceding claims, wherein the machine learning system is trained using a supervised learning approach comprising the steps of: providing a training dataset comprising a plurality of examples, each example including a time series (10) and a corresponding ground truth system of differential equations (70) representing the time series (10);
for each example in the training dataset:

Propagating the time series through the encoder (30) to obtain a signal encoding;
generating the shared embedding (50) with the signal encoding;
processing the corresponding ground truth of systems of differential equations (70) by the equation embedding (41) to obtain a ground truth equation embedding;
adding or concatenating the ground truth equation embedding (41) to the shared embedding (50);
decoding the shared embedding using the decoder (60) to generate a predicted system of differential equations;
calculating a loss value (80) based on a difference between the predicted system of differential equations and the ground truth system of differential equations (70);
updating parameters of the machine learning system based on the calculated loss value.

5. The method according to claim 4, the training dataset additionally comprises ground truth expert knowledge (91, 92) describing the corresponding ground truth system of differential equations (70), wherein the ground truth expert knowledge (91, 92) is added or concatenated to the equation embedding (41), together with the corresponding ground truth system of differential equations (70), to obtain the ground truth equation embedding.

6. A Computer program that is configured to cause a computer to execute the method according to any one of the preceding claims with all of its steps if the computer program is carried out by a processor.

7. A Machine-readable storage medium on which the computer program according to claim 6 is stored.

8. A System that is configured to carry out the method according to any one of claims 1-5

**Fig. 1**

**Fig. 2**

**Fig. 3**

Europäisches
Patentamt

European
Patent Office

Office européen
des brevets

# EUROPEAN SEARCH REPORT

**Application Number**

EP 24 22 2036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | S\"OREN BECKER ET AL: "Predicting Ordinary Differential Equations with Transformers", ARXIV.ORG, CORNELL UNIVERSITY LIBRARY, 201 OLIN LIBRARY CORNELL UNIVERSITY ITHACA, NY 14853, 24 July 2023 (2023-07-24), XP091571913, * abstract * * Section 3 * * Section 3.1 "Sampling symbolic expressions" * * Section 3.2 "Training" * * figure 1 * | 1-8 | INV. G06F16/906 G01R31/00 G06N3/00 |
| X | Stéphane D'ascoli ET AL: "ODEFormer: Symbolic Regression of Dynamical Systems with Transformers", , 9 October 2023 (2023-10-09), pages 1-29, XP093272348, Retrieved from the Internet: URL:https://arxiv.org/pdf/2310.05573 * abstract * * Section 3 * * Section 4 * * figure 2 * | 1-8 | |
| E | EP 4 528 591 A1 (BOSCH GMBH ROBERT [DE]) 26 March 2025 (2025-03-26) * the whole document * | 1-8 | TECHNICAL FIELDS SEARCHED (IPC) G06F G01R G06N |

The present search report has been drawn up for all claims

| Place of search | Date of completion of the search | Examiner |
|---|---|---|
| Berlin | 24 April 2025 | Pose Rodríguez, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 2036

This annex lists the patent family members relating to the patent documents cited in  the above-mentioned European search report.
The members are as contained in the European Patent Office EDP file on
The European Patent Office is in no way liable for these particulars which are merely given for the purpose of information.

24-04-2025

| Patent document cited in search report | | Publication date | Patent family member(s) | | Publication date |
|---|---|---|---|---|---|
| EP 4528591 | A1 | 26-03-2025 | CN | 119669618 A | 21-03-2025 |
| | | | EP | 4528591 A1 | 26-03-2025 |

EPO FORM P0459

For more details about this annex : see Official Journal of the European Patent Office, No. 12/82